# EUROPEAN PATENT SPECIFICATION

(11) **EP 1 316 090 B1**
(45) Date of publication and mention of the grant of the patent: **09.03.2005**
(21) Application number: 01985301.9
(22) Date of filing: 24.08.2001
(51) Int. Cl.: G11C 5/00

(54) **NON-VOLATILE PASSIVE MATRIX AND METHOD FOR READOUT OF THE SAME**
NICHTFLUECHTIGE PASSIVE SPEICHERARRAY UND SEIN LESEVERFAHREN
MATRICE PASSIVE REMANENTE ET SON PROCEDE D'AFFICHAGE

(30) Priority: 24.08.2000 NO 20004236
(43) Date of publication of application: 04.06.2003
(73) Proprietor: Thin Film Electronics ASA, 0124 Oslo (NO)
(72) Inventor: THOMPSON, Michael, Ithaca, NY 14853-1501 (US); WOMACK, Richard, Albuquerque, NM 87111-1305 (US); GUSTAFSSON, Göran, S-582 16 Linköping (SE); CARLSSON, Johan, S-589 29 Linköping (SE)
(74) Representative: Johnson, Terence Leslie
(86) International application number: PCT/NO2001/000348
(87) International publication number: WO 2002/025665

(56) References cited:
- EP-A- 0 486 901
- US-A- 4 599 709
- US-A- 4 982 368
- HIRANO H ET AL.: ' 2V/100NS 1T/1C NONVOLATILE FERROELECTRIC MEMORY ARCHITECTURE WITH BITLINE-DRIVEN READ SCHEME & NON-RELAXATION REFERENCE CELL' 1996 SYMPOSIUM ON VLSI CIRCUITS. DIGEST OF TECHNICAL PAPERS. HONOLULU, JUNE 13 - 15, 1996, SYMPOSIUM ON VLSI CIRCUITS, NEW YORK, IEEE, US 13 June 1996, pages 48 - 49, XP001084397

## Description

The present invention concerns a non-volatile passive matrix memory device comprising an electrically polarizable dielectric memory material exhibiting hysteresis, particularly a ferroelectric material, wherein said memory material is provided sandwiched in a layer between a first set and second set of respective parallel addressing electrodes, wherein the electrodes of the first set constitute word lines of the memory device and are provided in substantially orthogonal relationship to the electrodes of the second set, the latter constituting bit lines of the memory device, wherein a memory cell with a capacitor-like structure is defined in the memory material at the crossings between word lines and bit lines, wherein the memory cells of the memory device constitute the elements of a passive matrix, wherein each memory cell can be selectively addressed for a write/read operation via a word line and bit line, wherein a write operation to a memory cell takes place by establishing a desired polarization state in the cell by means of a voltage being applied to the cell via the respective word line and bit line defining the cell, wherein said applied voltage either establishes a determined polarization state in the memory cell or is able to switch between the polarization states thereof, and wherein a read operation takes place by applying a switching voltage Vₛ larger than the coercive voltage V_{c} to the memory cell and detecting at least one electrical parameter of an output current on the bit lines.

The invention further concerns a method according to the appended independent method claim.

The invention also concerns the use of a non-volatile passive matrix memory device in a volumetric data storage apparatus.

Ferroelectric integrated circuits have revolutionary properties compared to conventional technology. Applications include non-volatile information storage devices, in particular matrix memories having advantages such as high speed, virtually unlimited endurance and high write speed; properties recently only dreamed of.
Ferroelectric matrix memories can be divided into two types, one type containing active elements linked to the memory cells and one type without active elements. These two types will be described below.

A ferroelectric matrix memory having memory cells in the form of ferroelectric capacitors without active access elements such as an access transistor comprises a thin ferroelectric film with a set of parallel conducting electrodes ("word lines") deposited on one side and an essentially orthogonal set of conducting electrodes ("bit lines") deposited on the other side, which configuration is in the following referred to as a "passive matrix memory". In the passive matrix memory, individual ferroelectric memory cells are formed at the crossing points of the opposing electrodes creating a memory matrix comprising memory cells that can be individually accessed electrically by selective excitation of the appropriate electrodes from the edge of the matrix.

Another approach for providing a matrix memory is to modify each ferroelectric memory cell by including an active element, typically an access transistor in series with the ferroelectric capacitor. The access transistor controls the access to the capacitor and blocks unwanted disturb signals, for instance from neighbouring memory cells. The memory cell can typically include a ferroelectric capacitor and a n-channel metal-oxide-semiconductor field-effect transistor (in the following generically abbreviated "MOSFET" without indicating n-type or p-type for'sake of simplicity) having its gate connected to a word line. A source/drain region of the MOSFET is connected to a bit line. One electrode of the ferroelectric capacitor is connected to the source/drain region of the MOSFET and the other electrode of the capacitor is connected to a so-called "drive line". This is the conventional concept of today and is often provided as one transistor, one capacitor (1T-1C) memory cells. Other concepts are also well-known, including two transistors or more. However, all these concepts increase the number of transistors compared to the passive matrix memory, which implies a number of drawbacks such as decreasing the number of memory cells within a given area, with increasing complexity and high current consumption. Herein, these types of devices are in the following referred to as "active" matrix memories because of the "active" element, i. e. the transistor in each memory cell.

The present invention is, however, solely directed towards passive matrix memories without active elements, such as diodes or transistors that are locally associated to the memory cell.

Read and write operations in passive matrix memories may be performed by means of a so-called "partial word addressing", whereby only a portion, typically one of the memory cells on a given word line are read or written. To accomplish such a partial read or write operation the non-addressed cells on non-activated word lines or bit lines are voltage-biased according to a so-called "pulsing protocol" in order to avoid partial switching of the non-addressed cells. The choice of pulsing protocol depends on a number of factors, and different schemes have been proposed in the literature for applications involving ferroelectric memory materials exhibiting hysteresis. This is described for instance in the present applicant's co-pending Norwegian patent application No. 20003508 filed 7 July 2000. This application describes a protocol for a passive matrix memory. On the other hand, normally the biasing of the non-addressed cells causes disturb voltages, which can result in loss of memory content or give rise to leakage currents and other parasitic currents, here called "sneak currents", which can mask the current of an addressed memory cell during a read operation and thereby mask the data content during the read. Depending on the type of device in question, different criteria for avoiding or at least reducing disturbance of non-addressed memory cells can be defined, such as methods for sneak current cancellation. Another way is to lower the sensitivity of each cell in the matrix to small-signal disturbances, which can be achieved by cells that exhibit a non-linear voltage-current response, involving e.g. thresholding, rectification and/or various forms of hysteresis.

In order to improve the performance of both active and passive ferroelectric memory devices, the memory matrix can be internally divided, "segmented", into smaller blocks, so-called "segments", for instance to reduce power requirements. Normally this segmentation is transparent to a user. Another reason for segmentation is the problem with ferroelectric capacitors that they suffer from a so-called "fatigue", which means that after a ferroelectric capacitor has been switched a large number of times, say several millions, it cannot hold a remanent polarization and hence stops functioning. A solution to this particular problem can be smaller matrix segments to avoid switching an entire row of capacitors. This is disclosed for instance in US-A-5 567 636. Another document describing a segmented memory matrix is Gary F. Derbenwick & al., "Non-volatile Ferroelectric Memory for Space Applications", Celis Semiconductor Corporation, Colorado Springs. This document describes a segmented memory matrix able to reduce power requirements in an active matrix using a one transistor, one capacitor memory cell architecture (1T, 1C).

Examples of passive matrix memories employing ferroelectric memory material can be found in the literature dating back 40-50 years. For instance, W.J. Merz and J.R. Anderson described a barium titanate based memory in 1955 (W.J. Merz and J.R. Anderson, "Ferroelectric storage devices", Bell. Lab. Record. 1, pp. 335-342 (1955)), and similar work was also reported by others promptly thereafter (see, e.g. C.F. Pulvari "Ferroelectrics and their memory applications", IRE Transactions CP-3, pp. 3-11 (1956), and D.S. Campbell, "Barium titanate and its use as a memory store", J. Brit. IRE 17 (7), pp. 385-395 (1957)). Another example of a passive matrix memory can be found in IBM Technical Disclosure Bulletin, Vol. 37, No. 11, November 1994. However, none of these documents describe a solution to the problem with disturbed non-addressed cells.

Another approach to remedy the problem would be to modify the ferroelectric material in order to create a square-like hysteresis loop. However, also this has not yet been described in more detail.

Accordingly, there is a need of a passive matrix memory without the above negative attributes, such as disturbed non-addressed cells.

In the light of the above, it is an object of the invention to provide a passive matrix memory device which solves the problem with disturbed non-addressed memory cells. Another object of the invention is to provide a passive matrix memory device which minimizes the influence of cumulative signals from non-addressed cells during reading of stored data. Finally it is also an object of the invention to provide a readout method in a passive matrix memory device and compatible with the above-mentioned objects.

The above objects as well as further advantages and features are realized with a non-volatile passive memory matrix device according to the invention, which is characterized in that the word lines are divided into a number of segments, each segment comprising and being defined by a plurality of adjoining bit lines in the matrix, and that means are provided for connecting each bit line assigned to a segment with an associated sensing means, thus enabling simultaneous connection of all memory cells assigned to a word line on a segment for readout via the corresponding bit lines of the segment, each sensing means being adapted for sensing the charge flow in the bit line connected therewith in order to determine a logical value stored in the memory cell defined by the bit line. In a first advantageous embodiment of the memory device according to the invention the means for simultaneous connection of each bit line of a segment with associated sensing means during addressing are multiplexers. In that case the number of multiplexers may correspond to the largest number of bit lines defining a segment, each bit line of a segment being connected with a specific multiplexer. It is then preferred that the output of each multiplexer is connected with a single sensing means, and particularly the single sensing means can then be a sense amplifier.

In a second advantageous embodiment of the memory device according to the invention the means for simultaneous connection of each bit line of a segment to an associated sensing means during addressing is a gate means. In that case all the bit lines of a segment can be connected with a specific gate means, each gate means having a number of outputs corresponding to the number of bit lines in the respective segment, and each output of each gate means is connected with a specific bus line of an output data bus, the number of bus lines thus corresponding to largest number of bit lines in a segment, and each bus line being connected with a single sensing means.

Preferably the gate means then comprises pass gates and preferably the.. sensing means is a sense amplifier.

The above objects and other advantages and features are also realized with a readout method for a memory device according to the invention, whereby the method is characterized by dividing the word lines into a number of segments, each segment comprising and being defined by a number of adjacent bit lines in the matrix, connecting each bit line within a word line segment with an associated sensing means, activating according to the protocol one word line of a segment at a time by setting the potential of said one word line of the segment to the switching voltage Vₛ during at least a portion of the read cycle, while keeping all bit lines of the segment at zero potential, and determining the logical value stored in the individual memory cells sensed by the sensing means during the read cycle.

In an advantageous embodiment of the readout method according to the invention, all word lines and bit lines when no memory cell is read or written, are kept at a quiescent voltage of approximately 1/3 of the switching voltage Vₛ, one word line at a time is activated according to the protocol by setting the potential of said one word line of the segment to the switching voltage Vₛ during at least a portion of the read cycle, while all bit lines of the segment are kept at zero potential, and the logical value stored in the individual memory cells sensed by the sensing means during the read cycle is determined.

Finally, the above objects and other features and advantages are also achieved according to the invention with the use of the inventive non-volatile passive memory device and the inventive method for readout in a volumetric data storage apparatus with a plurality of stacked layers, each layer comprising one of the non-volatile passive matrix memory devices.

The invention shall now be more fully described on the basis of discussions of its general background and preferred embodiments presented hereinafter, when read in conjunction with the appended drawing figures, wherein
fig. 1 shows a principle drawing of a hysteresis curve for a ferroelectric memory material;
fig. 2 a schematic diagram of a portion of a passive memory matrix with crossing electrode lines and wherein the memory cells comprise a ferroelectric material localized between these electrodes where they overlap;
fig. 3 an enlarged cross-sectional view taken along line A-A in fig. 2;
fig. 4 a functional block diagram illustrating full word read in a ferroelectric matrix memory;
fig. 5 a functional block diagram illustrating a passive matrix memory according to a preferred embodiment of the invention and with segmented word lines;
fig. 6 a functional block diagram illustrating a passive matrix memory according to a preferred embodiment of the invention and with segmented word lines;
fig. 7a a simple full word read timing diagram with a following write/refresh cycle provided for addressing a word line of a segment of the memory matrix in "full word read";
fig. 7b a variant of the timing diagram in fig. 7a; and
fig. 8 the same embodiment as in fig. 5, but with electrical segmentation of the word lines,
fig. 9 the embodiment as in fig. 6, but with electrical segmentation of the word lines, and
fig. 10 schematically how the memory matrix in fig. 5 or 6 can be implemented in a volumetric memory device.

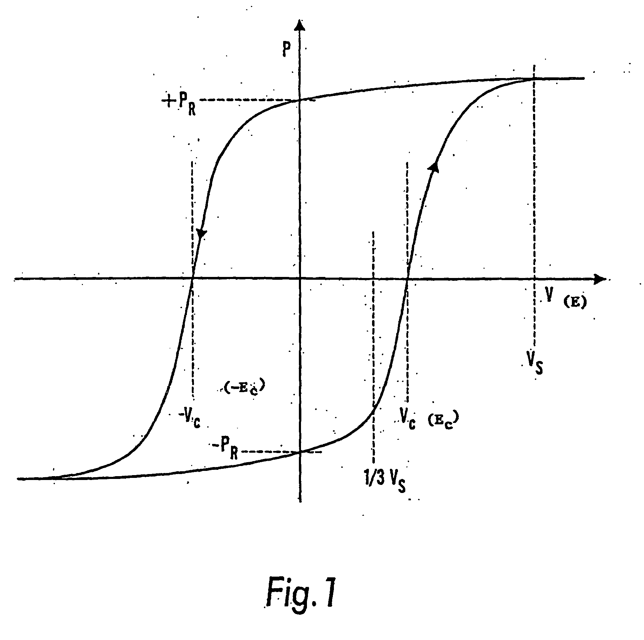

Before giving a detailed description of preferred embodiments, the general background of the present invention shall be discussed in order to give a better understanding of how a passive matrix memory, or even a single memory cell in such a memory works. In this connection reference is made to fig. 1, which shows a typical so-called ''hysteresis loop" of a ferroelectric material, whereas the polarization P of the ferroelectric material can be versus the electric field E and/or plotted with regard to a potential difference V. The value of the polarization will travel around the loop in the direction indicated. A ferroelectric material with a hysteresis loop as shown in fig. 1 will change its net polarization direction ("switching") upon application of an electric field (a voltage Vₛ) that exceeds a so-called coercive electric field E_{c} (voltage V_{c}). As the electric field E (voltage V) exceeds the coercive electric field E_{c} (V_{c}), polarization P changes abruptly to a large positive value +Pᵣ (assuming starting at negative polarization at zero electric field (potential). This positive polarisation +Pᵣ remains until a negative electric field (voltage -Vₛ) exceeding the negative coercive electric field E_{c} (voltage -V_{c}) changes the polarization again back to negative polarization. In this way, memory devices provided with capacitors comprising ferroelectric material will exhibit a memory effect in the absence of an applied external electric field, making it possible to store non-volatile data by applying a potential difference across the ferroelectric material, which evokes a polarization response. The direction (and magnitude) thereof may thus be set and left in a desired state. Likewise, the polarization status can be determined. Storing and determining data will be described in more detail below.

Depending on the required switching speed etc., a nominal voltage Vₛ employed for driving the polarization state of the ferroelectric material is typically selected considerably larger than the coercive voltage E_{c}. The nominal voltage Vₛ is generically illustrated with a dashed line in fig. 1, but is by no means limited to this particular value. Other values can be applicable.

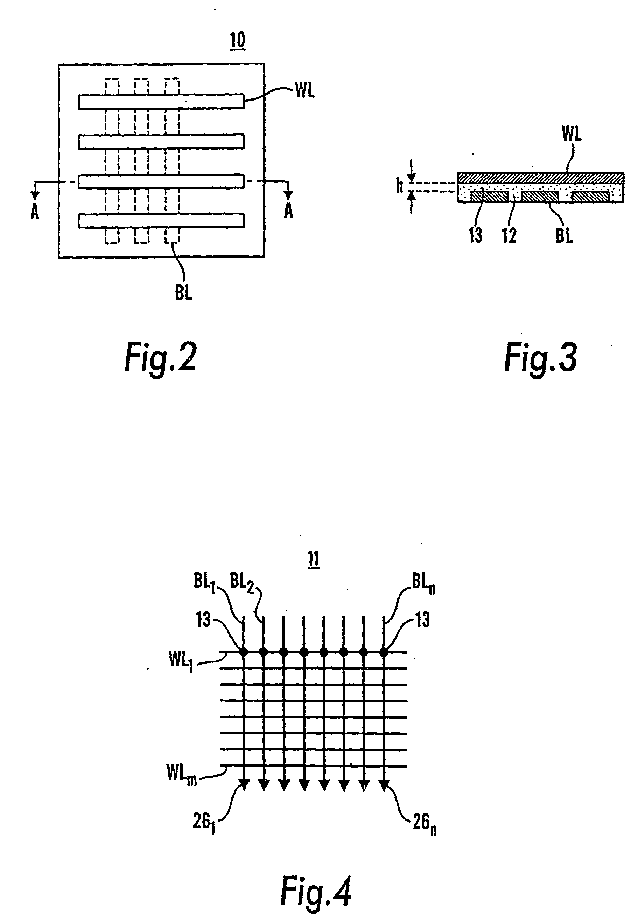

Fig. 2 illustrates a portion of a m·n memory matrix 11 of a passive matrix memory 10 showing two mutually opposing sets of parallel electrodes, viz. word line electrodes WL and bit line electrodes BL. The word line and the bit line electrodes WL;BL are arranged perpendicular to each other, whereby they at the intersecting areas define side walls of specific volume elements of an insulating ferroelectric material (described in more detail below) and which in its turn define the volume of capacitor-like memory cells in the memory matrix 11. Fig. 3 discloses a cross-sectional view along line A-A in fig. 2. The dielectric of each "capacitor" is the ferroelectric material in a ferroelectric layer 12, where the thickness of the material defines the height h of the volume elements which in their turn define the memory cells 13. - For reasons of simplicity, only three crossing points between the word line and bit line electrodes WL;BL are illustrated in fig. 2.

By application of a potential difference Vₛ between two opposing electrodes, the word line WL and the bit line BL in a cell 13, the ferroelectric material in the cell 13 is subjected to an electric field E which evokes a polarization response, having a direction which may be set and left in one of two stable states, positive or negative polarization, according to what is disclosed for instance in fig. 1. The two states represent the binary states "1" and "0". Likewise, the polarization status of the cell 13 may be altered or deduced by renewed application of a potential difference between the two opposing electrodes WL and BL addressing that cell 13, which either causes the polarization to remain unchanged after removal of the potential difference, or to flip to the opposite direction. In the former case, a small current will flow in response to the applied voltage, while in the latter case the polarization change causes a large current. The current is compared to a reference which can be provided in a number of ways (not shown) to be able to decide whether a "0" or a "1" is present. If the read is a destructive read, the polarization state in some of the cells will be switched to the opposite state. For instance can the polarization state of the cell be switched to "0" whether it is the state "1" or the state "0" that is read. The initial state must be written back to a cell in the memory to keep the information in the memory , i.e. the readout value. A more detailed description of how a passive matrix memory operates will be given in below when describing a preferred embodiment of the invention.

Also in order to improve the understanding of the present invention, reference can be made to fig. 4 illustrating another readout method for passive matrix memories, hereinafter called "full word read", whereby an active word line, herein the first word line WL₁ comprising a desired memory cell 13, is sensed over its entire word length, that is, each of the memory cells 13 defined by the bit lines BL₁,...BLₙ. Full word read per se is a known concept described for instance in US-A-6 157 578. In said document, however, the solution is directed to an active matrix memory device, with the purpose of increasing the speed of transferring data stored in a relatively large block of a memory matrix. The present invention is on the contrary related to passive matrix memories, whereby prior art knowledge regarding active matrices, such as described in US-A-6 157 578, is not relevant since active devices does not have the problem with disturbing non-addressed cells.

It is important to notice that according to the pulsing protocol for full word read in a passive matrix memory, unused word lines, in this case to the word lines WL_{2,...m} can be maintained at the same potential or essentially the same potential as the bit lines BL_{1,...n}. Consequently, there is no disturbing signal on any of the non-addressed cells of the memory matrix 10. For readout of data (sensing), the active word line, in this case the first word line WL₁, is brought to a potential causing current I to flow through the cells on the crossing bit lines BL_{1,...n}. The magnitude of the current I depends on the polarization state each cell 13 and are determined by sensing means 26, one for each bit line BL as shown in fig. 4. The sensing means can for instance be sense amplifiers.

The full word read method offers several advantages. For instance may the readout voltage be chosen much higher than the coercive voltage without incurring partial switching in non-addressed cells, and the method is compatible with a large matrix.

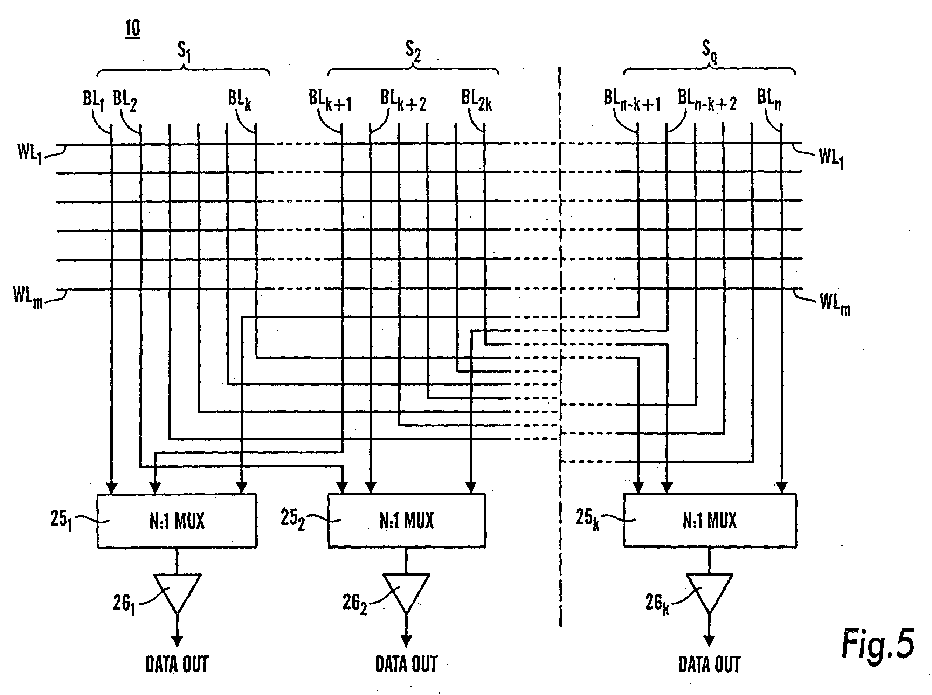

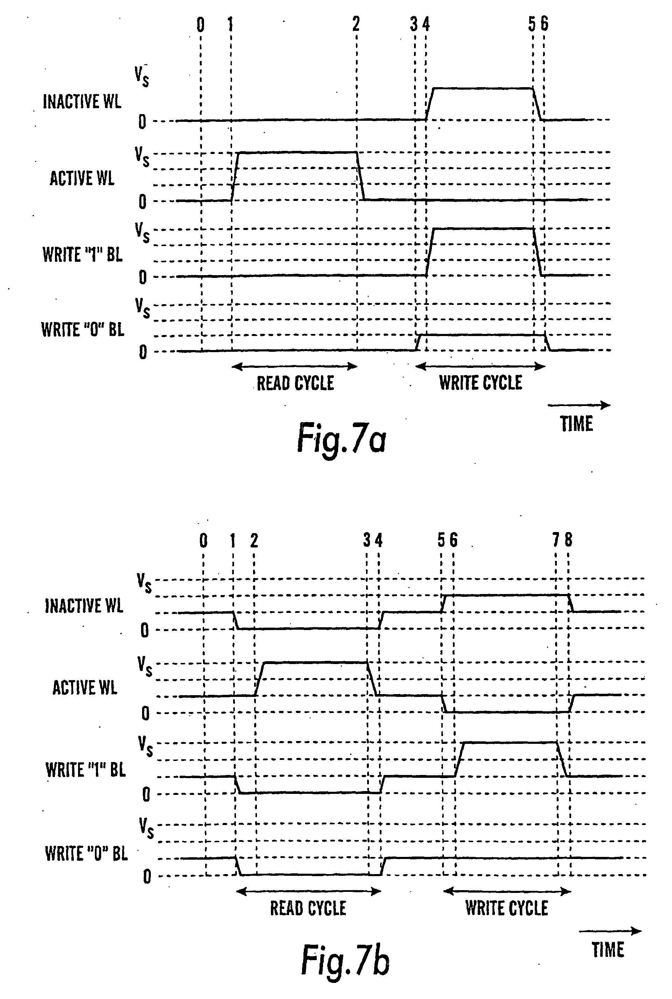

The preferred embodiments of the present invention are illustrated in figs. 5-7 of the drawings. An accompanying timing diagram that accomplishes zero volt disturb of non-addressed memory cells, while applying switching voltage Vₛ on all cells of the active word line WL₁ during reading of all cells in an active segment. A preferred timing diagram is shown in fig. 7a and an alternative timing diagram is disclosed in fig. 7b.

With reference to fig. 5 which shows a preferred embodiment of the passive matrix memory according to the present invention, the matrix proper is embodied as an m·n matrix formed by m word lines WL_{1,...m} and n bit lines BL_{1,...n}. The word lines are divided in q segments S, each segment S being defined by a number k adjacent bit lines BL in the matrix BL. Preferably k is the same for each segments, such that q·k = n. For readout the first bit line in each segment S can now be coupled by a first multiplexer 25₁ to a first sensing means 26₁. The second bit line in each segment shall correspondingly be coupled to another multiplexer 25₂, such that k'th line in each segment will be coupled to last multiplexer 25ₖ. The number of multiplexers (MUX) 25 shall in other words shall be equal to the largest number of bit lines BL which defines a segment. It is, of course, nothing that prevents that the number of bit lines in each segment S can be different, but if the memory cells on the bit lines on the segment contain data words with the same length, k will be the same for all segments. Each multiplexer 25 is connected with a sensing means 26 for readout of data and the number of sensing means 26 will hence also be equal to the largest number k bit lines BL which defines a segment. Different from conventional passive matrix memories which use partial word read, all the memory cells 13 in a word line segment n is connected simultaneously to the sensing means 26 such that all bit spots on a word line segment can be read out in parallel. Specifically can the sensing means be sense amplifiers. - For simplicity are only the two first segments S₁, S₂ and the last segment Sq rendered in fig. 5 and the same applies to the associated multiplexers 25 and sense amplifiers 26. - Data which are stored and/or shall be stored in the memory matrix 11 can be accessed by means of an associated row decoder and column decoder which is not shown in fig. 5 and the data which is stored in the memory cells 13 in the memory matrix 11 can be read out with a pulse protocol, e.g. as discussed in connection with fig. 7a via the sense amplifiers 26 which are connected to the bit lines over the multiplexers 25. All bit lines BL which define a word line segment S are routed to multiplexers 25 and are selected only when a given word line WL in this segment is active. In this manner all bit lines in the active word line WL in the segment S is read out in parallel in a "full word configuration" and all bit lines are distributed among the sense amplifiers 26.

In a practical embodiment the passive memory device can for instance be a 16 Mbit memory divided into 8 segments S, i.e. with q = 8 and comprise 256 000 word lines WL of each 64 bits. It will then be 8 bit lines BL in each segment S, in other words k = 8. Other architectures are of course, also possible, e.g. with 9, 16 or 32 bit lines in each segment S.

In another preferred embodiment of the invention at least 256 memory cells 13 are used in each segment S. With the use of a 32:1 multiplexers 25 this forms 8192 bits wide memory with only 32 duplication of word line drivers. Each word line will, of course, be segmented according to the number of provided sense amplifiers 26.

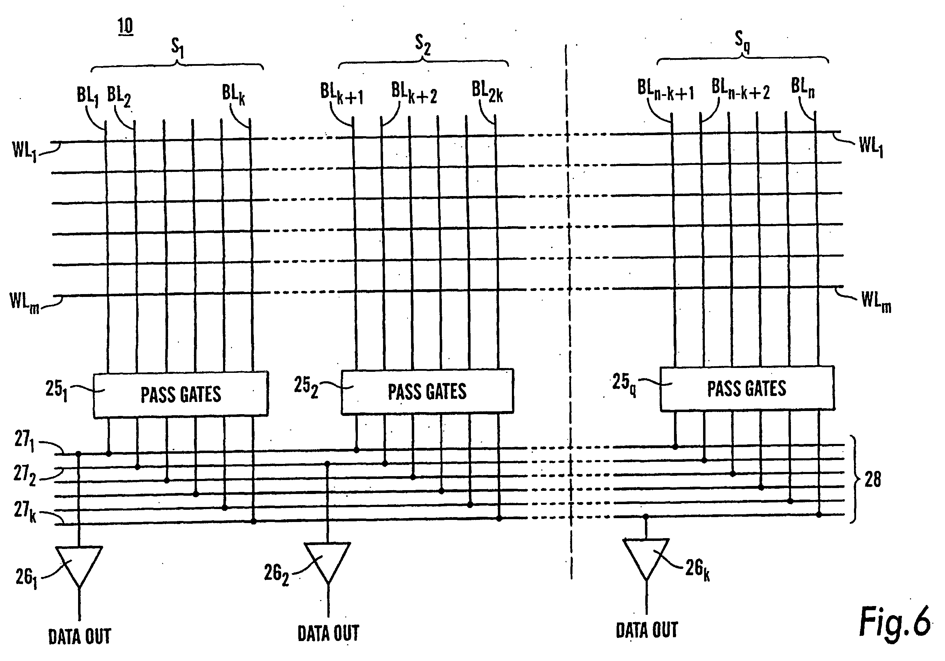

In fig. 6 there is shown an alternative embodiment of the memory device according to the present invention, wherein the multiplexers are replaced by gate means 25. The gate means 25 activate the bit lines BL in the same manner as the multiplexers.

Preferably, the gate means 25 are realized as pass gates connected with each bit line BL in a segment S. While the number of multiplexers 25 in the embodiment in fig. 5 shall be equal to the number of bit lines BL in the segment S, namely k, the number of pass gates 25 in the embodiment in fig. 6 shall correspond to the number q of segments S. The number of outputs on each pass gate 25 corresponds to the number of bit lines BL in the respective segment S. In order to maintain parallel readout of memory cells 13 of the active word line WL in the segment S, a sense amplifier 26 is used for each bit line BL in the segment, each sense amplifier 26 being connected to one of the lines 27 on a data bus 28. A first output of the pass gate is connected to the first bus line 27₁ and the second to the second bus line 27₂ etc. and the number of bus lines 27 and sense amplifiers will, of course, be the greatest number of bit lines BL which defines a segment S.

Figs. 7a and 7b render alternative timing diagrams for a full word read cycle.

Fig. 7a shows a timing diagram for full word read with a following write/read cycle ("refresh", "write back") for a word line segment. This timing diagram is based on a four-level voltage protocol. According to this timing diagram all word lines and all bit lines are, when no cell in the matrix is read or written, kept at a quiescent voltage equal to zero volts. All memory cells have an address which represent the crossings formed of an activated word line WL and by all bit lines BL within this segment which is to be read.

The inactive word lines WL and all bit lines BL follow the same potential curves during the read cycle. During the read cycle the word line contacting the cells to be read is set to switching voltage Vₛ. At the same time interval all bit lines are kept at zero voltage. In the timing diagram shown there is provided that application of the switching voltage Vₛ on the word line side of a cell and a zero voltage on the bit line side of the same cell implies that a "0" is written into the cell. According to this, in both timing diagrams shown all cells on the active word lines are set to the zero state after the read operation has been performed. Therefore, in order to restore data stored in the memory, it will be necessary to write back "1" only on the bit lines which has cells that should contain "1". This is shown in both examples in figures 7a and 7b, where a voltage with reversed polarity is applied to the cell which shall be written with "1" during the read cycle as indicated in the diagram.

Fig. 7b illustrates an alternate timing diagram based on a four-level voltage protocol. According to this embodiment all word lines and bit lines, when no cell in the matrix is read or written, are kept at a quiescent voltage Vₛ/3.

The exact values for all timing points illustrated as examples in figures 7a and 7b are dependent on the materials of the memory cells and the details of the design.

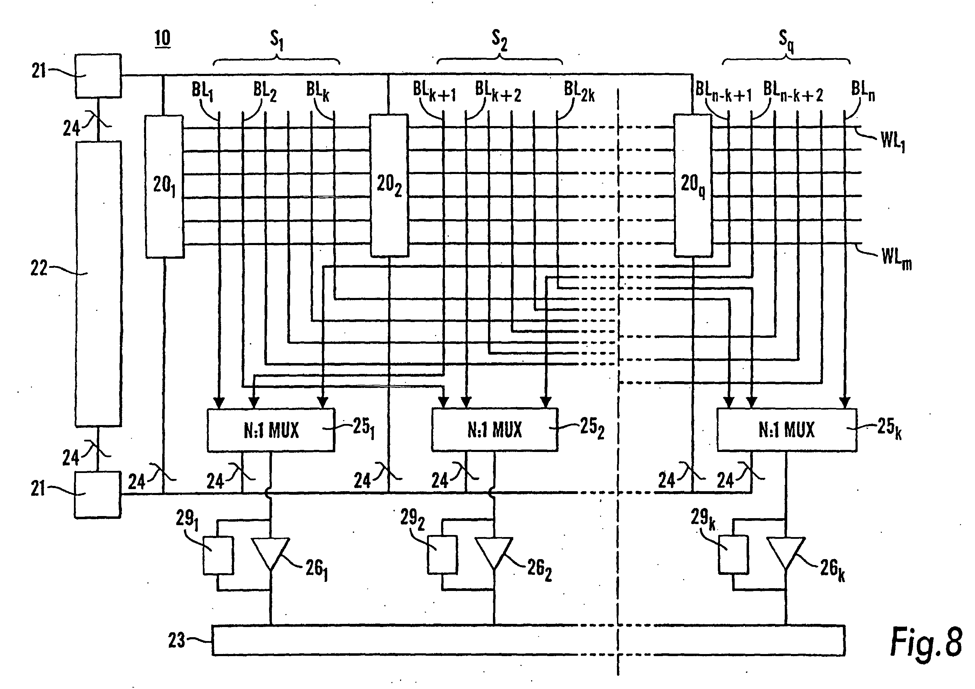

In the embodiments of fig. 5 and 6 the word lines could in principle be uninterrupted, i.e. that they are extending continuously to the separate segments, the segments only being defined by the bit lines in question. Multiplexing and protocols for read and write must then be adapted thereto. It is, however, no advantage that the word lines become too long. With a limited number of segments and a limited number of bit lines in each segments this is avoided, e.g. as in the above mentioned example, where 256 000 word lines and 8 segments with 8 bit lines in each segment are used. The memory then obtains as stated a storage capacity of 16 Mbits. There are, however, also other disadvantages with continuous word lines. If the bit spots of the memory cells in the segment S read with high voltage on the active word line, the same high voltage will be impressed on the active word line in all segments and even though only the bit lines in the addressed segments are connected, capacitive couplings and sneak currents can be formed and influence e.g. the memory cells in adjacent non-active word lines in the segment, something which may lead to spurious readouts or noise contributions. In a practical embodiment of the memory device according to the invention it will hence be relevant also to be able to segment the word lines electrically such that only the active word line within the addressed segment is connected electrically to the driver, while the corresponding word line segments in the remaining segments are disconnected. This will particularly be relevant when the protocol in fig. 7 is used and can take place with an embodiment of the memory device as shown in fig. 8, which in principle corresponds to that in fig. 5. A not shown driver in a driver group 20 is selected by means of a segment selector 22 which e.g. may be realized as a selector bus, such that the word line WL in the selected segment S is activated for a read or write cycle. The multiplexers 25 which are controlled by the segment selector means 22 can be connected with a selected driver in the group 20 via switches 24 and controlled via the selector means 22 over a switchable cache memory 21. The specific multiplexer 25 is simultaneously addressed for connecting the bit lines BL in the addressed segment to the sense amplifier 26. In purely practical terms each word line WL in a segment can be connected to an AND gate, e.g. a CMOS logic gate or a pass gate, and the segment be addressed from a word line or address decoder. For instance the word line WL₁ is selected in the segment S₁ and it is then voltage only on this word line within the segment S₁. With destructive readout now all memory cells and the word lines WL₁ in the segment S₁ will be switched to zero state, while the multiplexer 25 connects all bit lines in the segment S₁ to the respective sense amplifiers 26₁...26ₖ. All cells on the activated word line can hence be read out, i.e. a full word read is obtained if the word line of the segment is defined to contain a data word. While the state of all cells on the selected word line WL₁ then is detected, the remaining word lines WL₂...WLₘ and bit lines BL₁-BLₖ is kept on a quiescent voltage near the biasing points of the sense amplifiers 26 and in principle there will then be no disturbance contribution from the remaining cells of the segment. Neither will there be any bias voltage on the cells on the bit line, such that disturbing signals to the input of the sense amplifiers 26 can be generated. The data output of the sense amplifier 26 is conveyed to a two-way data bus 23 while a write logic 29 is connected in parallel on the output of the multiplexers for writing of data to the bit spots of the cells on an active word line in the segment, the word lines in the segments being selected in corresponding ways via the selector means 22 as in case of readout. Preferably there are provided buffer memories 21 on the switchable outputs of the selector means 22 and the latter connect drivers and multiplexers 25 via a number of line switches 24 controlled by the selector means 22.

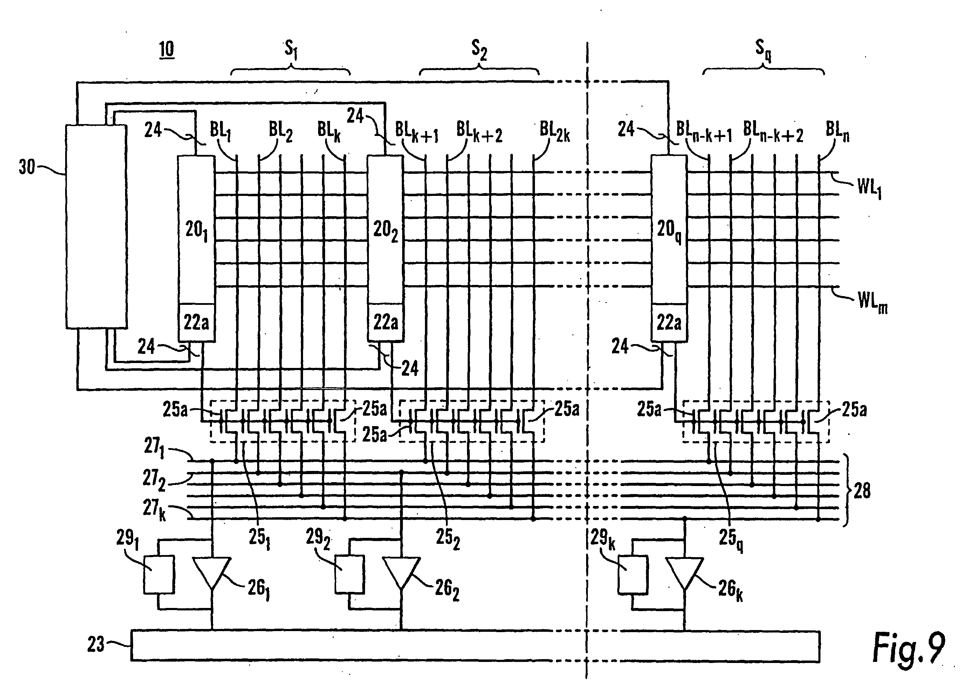

Fig. 9 shows an embodiment functionally equivalent to that of fig. 8, but which additionally corresponds to the embodiment in fig. 6 wherein the multiplexers have been replaced by pass means 25. Each pass means 25 can e.g. comprise switching transistors 25a which function as pass gates, one for each line such that there will be a total of k switching transistors 25a in a pass means 25. As is the case with the embodiment in fig. 8, driver groups 20 are provided, one for each segment, while the selector means 22 now is replaced by a driver group selector 22a. The addressing of the separate word line WL takes place over the output in a word line address bus 30 under control by the group selector 22a. In readout the bit lines 25a are connected to the bus line 27 in the data bus 28 and the data output of the sense amplifier is connected with a two-way data bus 23. Correspondingly as in fig. 8 the write logic 29 is provided in parallel over the sense amplifiers 26 and when writing takes place, the word line segment is selected via the group selectors 22a and with addressing over the word line address bus 30.

Basically the necessary devices and means for selection, decoding and addressing, like not shown timing logic, are well-known in the art and commonly employed in the matrix-addressable memories whether they are active or passive and hence shall not be discussed in further detail here.

The number of voltage levels and the voltage levels themselves in the pulsing protocol can be selected arbitrarily as long as the requirements for performing full word read are met. Further, the polarity of the voltages according to the protocols shown may as well be reversed.

In a practical circuit technology for the realization of the memory device according to the present invention, the memory matrix can be provided on a substrate and word line drivers integrated therein, such that the total area of the device does not increase.

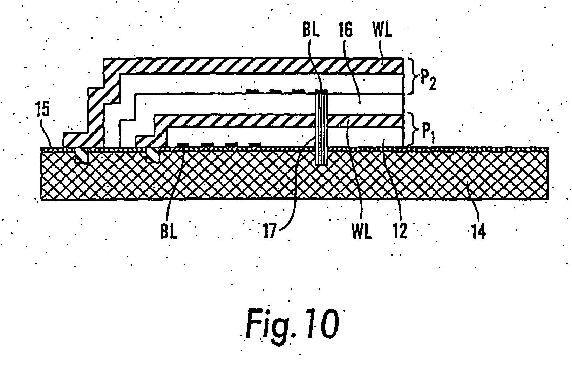

The segmented word lines could as well be implemented on stacked memory planes, with the bit lines BL connected vertically to the multiplexers or gate means 25. This is illustrated in fig. 10, which shows schematically and in cross section an embodiment wherein memory devices 10 according to the invention are provided in a stacked arrangement. This realizes a volumetric data storage apparatus wherein each layer or memory plane P comprises one memory device 10. By providing the memory devices in a staggered arrangement, the respective word lines and bit lines can be connected over so-called staggered vias, i.e. alternating horizontal and vertical "over-the-edge" connections with driver and control circuitry in the substrate 14. The substrate 14 can be inorganic, i.e. silicon-based, and hence the circuitry may be implemented in e.g. a compatible CMOS technology. Figure 8 shows only two memory planes P₁,P₂ (note that only a limited number of bit lines are shown), but in practice the volumetric data storage apparatus may comprise a very large number of memory planes, from 8 and well beyond 100 or more, realizing a memory with very high capacity and storage density, as each memory plane only will be about 1µm thick or even less.

Advantages of the passive matrix memory device described above include simplicity of manufacture and high density of cells. Further advantages are:
a) If the word lines are segmented electrically, non-addressed memory cells will during the read cycle be subjected to zero volt potential (or a small potential), given that the protocol according to fig. 7a is used. This will reduce the number of disturb signals that could result in loss of memory content as well as eliminate all disturbs during a read operation that give rise to sneak currents.
b) The data transfer rate will be at the maximum rate as allowed by the number of bit lines within a segment.
c) The readout voltage Vₛ may be chosen much higher than the coercive voltage without incurring partial switching in non-addressed cells. This allows for switching speeds approaching the highest possible speed of polarizable material in the cells.
d) The readout method is compatible with large matrices.

In addition the memory device of the invention can be realized with a reduced number of sense amplifiers, which is an advantage when the memory is large and also with regard to the power consumption of the sense amplifiers. This can be high, but may also be reduced to some extent by appropriate power management of the driving and addressing circuitry. Moreover, a reduction in the number of sense amplifiers implies that real estate devoted to sense means can be balanced to achieve overall area optimization in the memory device. Finally, the segmentation of the word lines implies that errors during readout or addressing will be located in a single word in the event of a single word line fault.

## Claims

1. A non-volatile passive matrix memory device (10) comprising an electrically polarizable dielectric memory material (12) exhibiting hysteresis, particularly a ferroelectric material, wherein said memory material (12) is provided sandwiched in a layer between a first set and second set (14; 15) of respective parallel addressing electrodes, wherein the electrodes of the first set (14) constitute word lines (WL_{1,...m}) of the memory device and are provided in substantially orthogonal relationship to the electrodes of the second set (15), the latter constituting bit lines (BL_{1,...n}) of the memory device, wherein a memory cell (13) with a capacitor-like structure is defined in the memory material (12) at the crossings between word lines and bit lines, wherein the memory cells (13) of the memory device constitute the elements of a passive matrix (11), wherein each memory cell (13) can be selectively addressed for a write/read operation via a word line (WL) and bit line (BL), wherein a write operation to a memory cell (13) takes place by establishing a desired polarization state in the cell by means of a voltage being applied to the cell via the respective word line (WL) and bit line (BL) defining the cell, wherein said applied voltage either establishes a determined polarization state in the memory cell (13) or is able to switch between the polarization states thereof, and wherein a read operation takes place by applying a voltage larger than the coercive voltage(V_{c}) to the memory cell (13) and detecting at least one electrical parameter of an output current on the bit lines (BL), **characterised in that** the word lines (WL) are divided into a number of segments (S_{1,..q}), each segment comprising and being defined by a plurality of adjoining bit lines (BL) in the matrix (11), and that means (25) are provided for connecting each bit line (BL) assigned to a segment (S) with an associated, sensing means (26), thus enabling simultaneous connection of all memory cells (13) assigned to a word line (WL) on a segment (S) for readout via the corresponding bit lines (BL) of the segment (S), each sensing means (26) being adapted for sensing the charge flow in the bit line (BL) connected therewith in order to determine a logical value stored in the memory cell (13) defined by the bit line.

2. A non-volatile passive matrix memory device (10) according to claim 1, **characterized in that** said means (25) for simultaneous connection of each bit line (BL) of a segment (S) with associated sensing means (26) during addressing are multiplexers.

3. A non-volatile passive matrix memory device (10) according to claim 2, **characterized in that** the number of multiplexers (25) corresponds to the largest number of bit lines (BL) defining a segment (S), each bit line of a segment being connected with a specific multiplexer.

4. A non-volatile passive matrix memory device (10) according to claim 3, **characterized in that** the output of each multiplexer (25) is connected with a single sensing means (26).

5. A non-volatile passive matrix memory device according to claim 4, **characterized in that** the single sensing means (26) is a sense amplifier.

6. A non-volatile passive matrix memory device according to claim 1, **characterized in that** said means (25) for simultaneous connection of each bit line (BL) of a segment (S) to an associated sensing means (26) during addressing is a gate means.

7. A non-volatile passive matrix memory device according to claim 6, **characterized in that** all bit lines (BL_{1,...n}) of a segment (S) are connected with a specific gate means, each gate means having a number of outputs corresponding to the number of bit lines (BL) in the respective segment (S), that each output of each gate means (25) is connected with a specific bus line (27) of an output data bus (28), the number of bus lines (27) thus corresponding to largest number of bit lines (BL) in a segment (S), and that each bus line (27) is connected with a single sensing means (26).

8. A non-volatile passive matrix memory device according to claim 6, **characterized in that** the gate means (25) comprise pass gates.

9. A non-volatile passive matrix memory device according to claim 6, **characterized in that** the sensing means (26) is a sense amplifier.

10. A method for readout of a non-volatile passive matrix memory device (10) comprising an electrically polarizable dielectric memory material (12) exhibiting hysteresis, particularly a ferroelectric material, wherein said memory material (12) is provided sandwiched in a layer between a first set and second set ( 14;15) of respective parallel addressing electrodes, wherein the electrodes of the first set (14) constitute word lines (WL) of the memory device (10) and are provided in substantially orthogonal relationship to the electrodes of the second set (15), the latter constituting bit lines (BL_{1,...n}) of the memory device (10), wherein a memory cell (13) with a capacitor-like structure is defined in the memory material (12) at crossings between word lines (WL) and bit lines (BL), wherein the memory cells (13) of the memory device (10) constitute the elements of a passive matrix (11), wherein each memory cell (13) can be selectively addressed for a write/read operation via a word line (WL) and bit line (BL), wherein write operation to a memory cell (13) takes place by establishing a desired polarization state in the cell by means of a voltage being applied to the cell via the respective word line (WL) and bit line (BL) defining the cell, said applied voltage either establishing a determined polarization state in the cell or being able to switch the cell between the polarization states thereof, wherein a read operation takes place by applying a voltage larger than the coercive voltag (V_{c}) to the memory cell (13) and detecting at least one electrical parameter of an output current on its bit lines (BL), and wherein the method comprises steps for controlling electric potentials on all word lines (WL) and bit lines (BL) in a time-coordinated fashion according to a protocol comprising electric timing sequences for all word lines and bit lines,
arranging said protocol to comprise a read cycle, and providing during the read cycle for the sensing means to sense charges flowing in the bit lines, and wherein the method is **characterized by** dividing the word lines (WL) into a number of segments (S₁,...S_{q}), each segment comprising and being defined by a number of adjacent bit lines (BL) in the matrix (11), connecting each bit line (BL) within a word line segment (S) with an associated sensing means (26),
activating according to the protocol one word line (WL) of a segment (S) at a time by setting the potential of said one word line (WL) of the segment (S) to the switching voltage Vₛ during at least a portion of the read cycle, while keeping all bit lines of the segment (S) at zero potential, and
determining the logical value stored in the individual memory cells (13) sensed by the sensing means (26) during the read cycle.

11. Method for readout according to claim 10,
**characterized by**
keeping all word lines (WL) and bit lines (BL) when no memory cell (13) is read or written, at a quiescent voltage of approximately 1/3 of the switching voltage (Vₛ), activating according to the protocol one word line (WL) at a time by setting the potential of said one word line (WL) of the segment (S) to the switching voltage Vₛ during at least a portion of the read cycle, while keeping all bit lines (BL) of the segment (S) at zero potential, and
determining the logical value stored in the individual memory cells (13) sensed by the sensing means (26) during the read cycle.

12. The use of a non-volatile passive matrix memory device (10) according to claim 1 and a method for readout according to claim 10 in a volumetric data storage apparatus with a plurality of stacked layers (P₁, P₂,...), each layer (P) comprising one of the non-volatile passive matrix, memory devices (10).

## Patentansprüche

1. Nicht-flüchtige passive Matrixspeichereinrichtung (10), umfassend ein elektrisch polarisierbares dielektrisches Speichermaterial (12), das eine Hysterese, insbesondere ein ferromagnetisches Material, wobei das Speichermaterial (12) in einer Schicht zwischen einem ersten Satz und einem zweiten Satz (14; 15) von jeweiligen parallelen Adressierungselektroden eingebettet ist, wobei die Elektroden des ersten Satzes (14) Wortleitungen (WL_{1,...m}) der Speichereinrichtung bilden und in einer im Wesentlichen orthogonalen Beziehung zu den Elektroden des zweiten Satzes (15) sind, wobei die letzteren Bitleitungen (BL_{1,...n}) der Speichereinrichtung bilden, wobei eine Speicherzelle (13) mit einer Kondensator-artigen Struktur in dem Speichermaterial (12) an den Überschneidungen zwischen Wortleitungen und Bitleitungen definiert wird, wobei die Speicherzellen (13) der Speichereinrichtung die Elemente einer passiven Matrix (11) bilden, wobei jede Speicherzelle (13) selektiv für einen Schreib/Lese-Betrieb über eine Wortleitung (WL) und eine Bitleitung (BL) gewählt werden kann, wobei ein Schreibbetrieb an eine Speicherzelle (13) stattfindet, indem ein gewünschter Polarisationszustand in der Zelle mit Hilfe einer Spannung eingerichtet wird, die an die Zelle über die jeweilige Wortleitung (WL) und die Bitleitung (BL), die die Zelle definieren, angelegt wird, wobei die angelegte Spannung entweder einen bestimmten Polarisationszustand in der Speicherzelle (13) einrichtet oder in der Lage ist zwischen den Polarisationszuständen davon umzuschalten, und wobei ein Lesebetrieb dadurch stattfindet, dass eine Spannung, die größer als die Koerzitivspannung (V_{c}) ist, an die Speicherzelle (13) angelegt wird und wenigstens ein elektrischer Parameter eines Ausgangsstroms der Bitleitungen (BL) erfasst wird, **dadurch gekennzeichnet, dass** die Wortleitungen (WL) in eine Anzahl von Segmenten (S_{1,...q}) aufgeteilt sind, wobei jedes Segment eine Vielzahl von angrenzenden Bitleitungen (BL) in der Matrix (11) umfasst und durch diese definiert wird, und dass eine Einrichtung (25) zum Verbinden jeder Bitleitung (BL), die zu einem Segment (S) zugewiesen ist, mit einer zugehörigen Erfassungseinrichtung (26) vorgesehen ist, sodass eine gleichzeitige Verbindung von sämtlichen Speicherzellen (13), die einer Wortleitung (WL) auf einem Segment (S) für eine Auslesung über die entsprechenden Bitleitungen (BL) des Segments (S) zugewiesen sind, ermöglicht wird, wobei jede Erfassungseintichtung (26) zum Erfassen des Ladungsflusses in der Bitleitung (BL), die damit verbunden ist, ausgelegt ist, um einen logischen Wert zu bestimmen, der in der Speicherzelle (13) gespeichert ist, die durch die Bitleitung definiert wird.

2. Nicht-flüchtige passive Matrixspeichereinrichtung (10) nach Anspruch 1, **dadurch gekennzeichnet, dass** die Einrichtung (25) für eine gleichzeitige Verbindung von jeder Bitleitung (BL) eines Segments (S) mit einer zugehörigen Erfassungseinrichtung (26) während einer Adressierung Multiplexer sind.

3. Nicht-flüchtige passive Matrixspeichereinrichtung (10) nach Anspruch 2, **dadurch gekennzeichnet, dass** die Anzahl von Multiplexern (25) der größten Anzahl von Bitleitungen (BL), die ein Segment (S) definieren, entspricht, wobei jede Bitleitung eines Segments mit einem spezifischen Multiplexer verbunden ist.

4. Nicht-flüchtige passive Matrixspeichereinrichtung (10) nach Anspruch 3, **dadurch gekennzeichnet, dass** der Ausgang von jedem Multiplexer (25) mit einer einzelnen Erfassungseinrichtung (26) verbunden ist.

5. Nicht-flüchtige passive Matrixspeichereinrichtung nach Anspruch 4, **dadurch gekennzeichnet, dass** die einzelne Erfassungseinrichtung (26) ein Erfassungsverstärker ist.

6. Nicht-flüchtige passive Matrixspeichereinrichtung nach Anspruch 1, **dadurch gekennzeichnet, dass** die Einrichtung (25) für eine gleichzeitige Verbindung von jeder Bitleitung (BL) eines Segments (S) mit einer zugehörigen Erfassungseinrichtung (26) während einer Adressierung eine Gattereinrichtung ist.

7. Nicht-flüchtige passive Matrixspeichereinrichtung nach Anspruch 6, **dadurch gekennzeichnet, dass** alle Bitleitungen (BL_{1,....n}) eines Segments (S) mit einer spezifischen Gattereinrichtung verbunden sind, wobei jede Gattereinrichtung eine Anzahl von Ausgängen entsprechend zu der Anzahl von Bitleitungen (BL) in dem jeweiligen Segment (S) aufweist, dass jeder Ausgang jeder Gattereinrichtung (25) mit einer spezifischen Busleitung (27) eines Ausgangsdatenbusses (28) verbunden ist, wobei die Anzahl von Busleitungen (27) somit der größten Anzahl von Bitleitungen (BL) in einem Segment (S) entspricht, und dass jede Busleitung (27) mit einer einzelnen Erfassungseinrichtung (26) verbunden ist.

8. Nicht-flüchtige passive Matrixspeichereinrichtung nach Anspruch 6, **dadurch gekennzeichnet, dass** die Gattereinrichtung (25) Weitergabegatter umfassen.

9. Nicht-flüchtige passive Matrixspeichereinrichtung nach Anspruch 6, **dadurch gekennzeichnet, dass** die Erfassungseinrichtung (26) ein Erfassungsverstärker ist

10. Verfahren zum Auslesen einer nicht-flüchtigen passiven Matrixspeichereinrichtung (10), die ein elektrisch polarisierbares dielektrisches Speichermaterial (12), das eine Hysterese aufzeigt, insbesondere ein ferroelektrisches Material, umfasst, wobei das Speichermaterial (12) in einer Schicht zwischen einem ersten Satz und einem zweiten Satz (14; 15) von jeweiligen parallelen Adressierungselektroden eingebettet ist, wobei die Elektroden des ersten Satzes (14) Wortleitungen (WL) der Speichereinrichtung (10) bilden und in einer im Wesentlichen orthogonalen Beziehung zu den Elektroden des zweiten Satzes (15) vorgesehen sind, wobei die letzteren Bitleitungen (BL_{1,....n}) der Speichereinrichtung (10) bilden, wobei eine Speicherzelle (13) mit einem Kondensator-ähnlichen Aufbau in dem Speichermaterial (12) an Überschneidungen zwischen Wortleitungen (WL) und Bitleitungen (BL) definiert wird, wobei, die Speicherzellen (13) der Speichereinrichtung (10) die Elemente einer passiven Matrix (11) bilden, wobei jede Speicherzelle (13) für einen Schreib/Lesebetrieb über eine Wortleitung (WL) und Bitleitung (BL) selektiv adressiert werden kann, wobei ein Schreibbetrieb an eine Speicherzelle (13) stattfindet, indem ein gewünschter Polarisationszustand in der Zelle mit Hilfe einer Spannung eingerichtet wird, die an die Zelle über die jeweilige Wortleitung (WL) und Bitleitung (BL) angelegt wird, die die Zelle definieren, wobei die angelegte Spannung entweder einen gegebenen Polarisationszustand in der Zelle einrichtet oder in der Lage ist die Zelle zwischen ihren Polarisationszuständen zu schalten, wobei ein Lesebetrieb stattfindet, indem eine Spannung größer als die Koerzitivspannung (V₀) an die Speicherzelle (13) angelegt wird und wenigstens ein dielektrischer Parameter eines Ausgangsstroms auf seinen Bitleitungen (BL) erfasst wird, und wobei das Verfahren Schritte zum Steuern von elektrischen Potentialen auf sämtlichen Wortleitungen (WL) und Bitleitungen (BL) in einer zeitlich koordinierten Weise in Übereinstimmung mit einem Protokoll, welches elektrische Timingsequenzen für sämtliche Wortleitungen und Bitleitungen umfasst, Anordnen des Protokolls, um einen Lesezyklus zu umfassen, und Ermöglichen, dass die Erfassungseinrichtwrg während des Lesezyklus Ladungen erfasst, die in den Bitleitungen fließen, umfasst und wobei das Verfahren **gekennzeichnet ist durch** Aufteilen der Wortleitungen (WL) in eine Anzahl von Segmenten (S_{1,}...S_{q}), wobei jedes Segment eine Anzahl von angrenzenden Bitleitungen (BL) in der Matrix (11) umfasst und **durch** diese definiert wird, Verbinden jeder Bitleitung (BL) innerhalb eines Wortleitungssegments (S) mit einer zugehörigen Erfassungseinrichtung (26), Aktivieren einer Wortleitung (WL) eines Segments (S) in Übereinstimmung mit dem Protokoll zu einer Zeit **durch** Einstellen des Potentials der einen Wortleitung (WL) des Segments (S) auf die Schaltspannung Vₛ während wenigstens eines Abschnitts des Lesezyklus, während sämtliche Bitleitungen des Segments (S) auf einem Null-Potential gehalten werden, und Bestimmen des logischen Werts, der in den individuellen Speicherzellen (13) gespeichert wird, die **durch** die Erfassungseinrichtung (26) während des Lesezyklus erfasst werden.

11. Verfahren zum Auslesen nach Anspruch 10, **gekennzeichnet durch** ein Halten von sämtlichen Wortleitungen (WL) und Bitleitungen (BL), wenn keine Speicherzelle (13) gelesen oder beschrieben wird, auf einer Ruhespannung von ungefähr 1/3 der Schaltspannung (Vₛ), Aktivieren einer Wortleitung (WL) in Übereinstimmung mit dem Protokoll zu einer Zeit **durch** Einstellen des Potentials der einen Wortleitung (WL) des Segments (S) auf die Schaltspannung (Vₛ) während wenigstens eines Abschnitts des Lesezyklus, während sämtliche Bitleitungen (BL) des Segments (S) auf einem Null-Potential gehalten werden, und Bestimmen des logischen Werts, der in den individuellen Speicherzellen (13) gespeichert ist, die **durch** die Erfassungseinrichtung (26) während des Lesezyklus erfasst werden.

12. Verwendung einer nicht-flüchtigen passiven Matrixspeichereinrichtung (10) nach Anspruch 1 und eines Verfahrens zum Auslesen nach Anspruch 10 in einer volumetrischen Datenspeichervorrichtung mit einer Vielzahl von gestapelten Schichten (P₁, P₂,...), wobei jede Schicht (P) eine der Nicht-flüchtigen passiven Matrixspeichereinrichtungen (10) umfasst.

## Revendications

1. Dispositif de mémoire à matrice passive non volatile (10) comprenant un matériau de mémoire diélectrique électriquement polarisable (12) montrant une hystérésis, particulièrement un matériau ferroélectrique, dans lequel ledit matériau de mémoire (12) est intercalé en sandwich dans une couche entre un premier ensemble et un second ensemble (14, 15) d'électrodes d'adressage parallèles respectives, où les électrodes du premier ensemble (14) constituent des lignes de mots (WL_{1,...m}) du dispositif de mémoire et sont fournies dans une relation substantiellement orthogonale aux électrodes du second ensemble (15), les dernières constituant des lignes de bit (BL_{1,} ...ₙ) du dispositif de mémoire, dans lequel une cellule de mémoire (13) avec une structure ressemblant à un condensateur est définie dans le matériau de mémoire (12) à des intersections entre des lignes de mots et des lignes de bit, dans lesquelles les cellules de mémoire (13) du dispositif de mémoire constituent les éléments de matrice passive (11), dans laquelle chaque cellule de mémoire (13) peut être adressée de façon sélective pour une opération d'écriture/lecture via une ligne de mots (WL) et une ligne de bit (BL), dans lesquelles une opération d'écriture dans une cellule de mémoire (13) a lieu en établissant un état de polarisation voulu dans la cellule au moyen d'une tension appliquée à la cellule via la ligne de mot (WL) respectif et une ligne de bit (BL) définissant la cellule, dans laquelle ladite tension appliquée soit établit un état de polarisation déterminé dans la cellule de mémoire (13) soit est capable de commuter entre des états de polarisation de celles-ci, et dans lequel une opération de lecture a lieu en appliquant une tension plus grande que la tension coercitive (V_{c}) à la cellule de mémoire (13) et en détectant au moins un paramètre électrique d'un courant de sortie sur les lignes de bit (BL), **caractérisé en ce que** les lignes de mots (WL) sont divisées en un nombre de segments (S_{1, ...q}), chaque segment comprenant et étant défini par une pluralité de lignes de bit adjointes (BL) dans la matrice (11), et ces moyens (25) sont fournis pour raccorder chaque ligne de bit (BL) assigné à un segment (S) avec un moyen de détection associé (26), permettant ainsi une connexion simultanée de toutes les cellules de mémoire (13) assignées à une ligne de mot (WL) sur un segment (S) pour l'extraction via les lignes de bit (BL) correspondantes du segment (S), chaque moyen de détection (26) étant adapté pour détecter le flux de charge dans la ligne de bit (BL) raccordée entre eux afin de déterminer une valeur logique stockée dans la cellule de mémoire (13) définie par la ligne de bit.

2. Dispositif de mémoire à matrice passive non volatile (10) selon la revendication 1, **caractérisé en ce que** lesdits moyens (25) pour une connexion simultanée de chaque ligne de bit (BL) d'un segment (S) avec des moyens de détection associés (26) pendant l'adressage sont des multiplexeurs.

3. Dispositif de mémoire à matrice passive non volatile (10) selon la revendication 2, **caractérisé en ce que** le nombre de multiplexeurs (25) correspond au nombre le plus grand de lignes de bit (BL) définissant un segment (S), chaque ligne de bit d'un segment étant raccordée à un multiplexeur spécifique.

4. Dispositif de mémoire à matrice passive non volatile (10) selon la revendication 3, **caractérisé en ce que** la sortie de chaque multiplexeur (25) est raccordée à un moyen de détection unique (26).

5. Dispositif de mémoire à matrice passive non volatile selon la revendication 4, **caractérisé en ce que** le moyen de détection unique (26) est un amplificateur de détection.

6. Dispositif de mémoire à matrice passive non volatile selon la revendication 1, **caractérisé en ce que** ledit moyen (25) pour une connexion simultanée de chaque ligne de bit (BL) d'un segment (S) à un moyen de détection unique (26) pendant l'adressage est un moyen de grille.

7. Dispositif de mémoire à matrice passive non volatile selon la revendication 6, **caractérisé en ce que** toutes les lignes de bit (BL_{1,} ...ₙ) d'un segment (S) sont raccordées à un moyen de grille spécifique, chaque moyen de grille ayant un nombre de sorties correspondant au nombre de lignes de bit (BL) dans le segment respectif (S), où chaque sortie de chaque moyen de grille (25) est raccordée avec une ligne de bus spécifique (27) d'un bus de données de sortie (28), le nombre de lignes de bus (27) correspondant donc au plus grand nombre de lignes de bit (BL) dans un segment (S), et **en ce que** chaque ligne de bus (27) est raccordée avec un moyen de détection unique (26).

8. Dispositif de mémoire à matrice passive non volatile selon la revendication 6, **caractérisé en ce que** le moyen de grille (25) comprend des grilles de passage.

9. Dispositif de mémoire à matrice passive non volatile selon la revendication 6, **caractérisé en ce que** le moyen de détection (26) est un amplificateur de détection.

10. Procédé pour extraire un dispositif de mémoire à matrice passive non volatile (10) comprenant un matériau de mémoire diélectrique électriquement polarisable (12) montrant une hystérésis, particulièrement un matériau ferroélectrique, dans lequel ledit matériau de mémoire (12) est intercalé en sandwich dans une couche entre un premier ensemble et un second ensemble (14, 15) d'électrodes d'adressage parallèles respectives, dans lesquelles les électrodes du premier ensemble (14) constituent des lignes de mots (WL) du dispositif de mémoire (10) et sont fournies dans une relation substantiellement orthogonale aux électrodes du second ensemble (15), les dernières constituant des lignes de bit (BL₁, _{...n}) du dispositif de mémoire (10), dans lequel une cellule de mémoire (13) avec une structure ressemblant à un condensateur est définie dans le matériau de mémoire (12) à des intersections entre des lignes de mots (WL) et des lignes de bit (BL), dans lesquelles les cellules de mémoire (13) du dispositif de mémoire (10) constituent les éléments d'une matrice passive (11), dans lesquels chaque cellule de mémoire (13) peut être adressée de façon sélective pour une opération d'écriture/lecture via une ligne de mot (WL) et une ligne de bit (BL), dans lequel l'opération d'écriture dans la cellule de mémoire (13) a lieu en établissant un état de polarisation voulu dans la cellule au moyen d'une tension appliquée à la cellule via la ligne de mot (WL) respective et la ligne de bit (BL) définissant la cellule, ladite tension appliquée établit soit un état de polarisation déterminé dans la cellule, soit elle est capable de commuter la cellule entre les états de polarisation de celui-ci, dans lequel une opération de lecture a lieu en appliquant une tension plus grande que la tension coercitive (V_{c}) à la cellule de mémoire (13) et en détectant au moins un paramètre électrique d'un courant de sortie sur ses lignes de bit (BL), et dans lequel le procédé comprend les étapes de commande des potentiels électriques sur toutes les lignes de mots (WL) et les lignes de bit (BL) d'une manière coordonnée dans le temps selon un protocole comprenant des séquences de temporisation électrique pour toutes les lignes de mots et les lignes de bit,
la disposition dudit protocole pour comprendre un cycle de lecture, et
la fourniture pendant le cycle de lecture pour le moyen de détection de détecter des charges passant dans les lignes de bit, et dans lequel le procédé est **caractérisé par** la division des lignes de mots (WL) en un nombre de segment (S₁, ...S_{q}), chaque segment comprenant et étant défini par un nombre de lignes de bit (BL) adjacentes dans la matrice (11), raccordant chaque ligne de bit (BL) dans un segment de ligne de mot (S) avec un moyen de détection (26) associé,
l'activation selon le protocole d'une ligne de mot (WL) d'un segment (S) au moment du réglage du potentiel de ladite une ligne de mot (WL) du segment (S) à la tension de commutation V, pendant au moins une partie du cycle de lecture, tout en maintenant toutes les lignes de bit du segment (S) à un potentiel de zéro, et
la détermination de la valeur logique stockée dans les cellules de mémoire (13) individuelles détectée par le moyen de détection (26) pendant le cycle de lecture.

11. Procédé d'extraction selon la revendication 10, **caractérisé par**
le maintien de toutes les lignes de mots (WL) et les lignes de bit (BL) lorsque aucune cellule de mémoire (13) n'est lue ou écrite, à une tension inactive d'approximativement 1/3 de la tension de commutation (Vₛ),
l'activation selon le protocole d'une ligne de mot (WL) au moment du réglage du potentiel de ladite une ligne de mot (WL) du segment (S) à la tension de commutation Vₛ pendant au moins une partie du cycle de lecture, tout en maintenant toutes les lignes de bit (BL) du segment (S) à un potentiel de zéro, et
la détermination de la valeur logique stockée dans les cellules de mémoire (13) individuelles détectée par le moyen de détection (26) pendant le cycle de lecture.

12. Utilisation d'un dispositif de mémoire à matrice passive non volatile (10) selon la revendication 1 et procédé pour extraire selon la revendication 10 dans un appareil de stockage de données volumétriques avec une pluralité de couches empilées (P₁, P₂, ...), chaque couche (P) comprenant un des dispositifs de mémoire à matrice passive non volatile (10).
